# EUROPEAN PATENT APPLICATION

(11) **EP 2 757 587 A1**
(43) Date of publication of application: **23.07.2014**
(21) Application number: 14151728.4
(22) Date of filing: 20.01.2014
(51) Int. Cl.: H01L 27/146, G02B 5/28, G02B 26/00

(54) **Optical device storage package, optical filter device, optical module, and electronic apparatus**

(30) Priority: 22.01.2013 JP 2013009018
(71) Applicant: Seiko Epson Corporation, Tokyo 163-0811 (JP)
(72) Inventor: Imai, Hideo, Nagano 392-8502 (JP); Matsuno, Yasushi, Nagano 392-8502 (JP); Koike, Shigemitsu, Nagano 392-8502 (JP); Saito, Daisuke, Nagano 392-8502 (JP)
(74) Representative: HOFFMANN EITLE

(57) **Abstract**

A optical device storage package includes a storage portion configured to store an optical device (etalon), a base portion which constitutes a bottom portion of the storage portion, a side wall portion which is integrally molded with the base portion and which constitutes a side surface portion of the storage portion, and a first lid portion joined to the side wall portion so as to cover the storage portion, constituting a top portion opposing the bottom portion of the storage portion and hermetically sealing the top portion, wherein the first lid portion is formed of a light-transmissive member.

## Description

### BACKGROUND

### 1. Technical Field

The present invention relates to an optical device storage package, an optical filter device, an optical module, and an electronic apparatus.

### 2. Related art

In the related art, known examples of an electronic device include image pickup devices using a CCD (Charge Coupled Device) or a CMOS (Complementary Metal Oxide Semiconductor), display devices such as a DMD (Digital Mirror Device) and optical filters such as an etalon filter. These optical devices are generally stored in a storage container (optical device storage package) sealed by a lid member having a light transmissive portion for preventing mechanical impacts from the outside or entry of moisture or obtaining desirable device characteristics under reduced-pressure environment.

The optical device is mounted on various electronic apparatuses used under various environments. Therefore, being compact, light weight, highly-reliable, and high environmentally-resistant performance are required for the storage containers. For example, JP-A-2005-79146 proposes a storage container in which some thought is put into shapes of a joint portion between a metal frame and a window member which constitute the lid member so as to achieve sealing having a desirable reliability in hermeticity without causing destruction of the window member or breakage of a low-melting-point glass at a joint portion, and without breaking up the joint portion between the metal frame and the window member even when a large thermal stress is generated between the metal frame and the window member.

However, the storage container disclosed in JP-A-2005-79146 has a problem that the low-melting-point glass at the joint portion may be broken when a larger thermal stress is generated such as a case where coefficients of thermal expansion of the metal frame and the window member are significantly different from each other. Since the metal frame, the window member, and the low-melting-point glass for joining these members need to be provided as a lid member, there is a problem of an increased number of components and an increase in costs. In addition, this structure needs a plurality of joint portions such as the joint portion between the metal frame and the window member and a joint portion between a base body (case body) and the lid member (metal frame) . Therefore, in order to secure high reliability in sealing hermeticity, strict control of members which constitute the joint portions and a joint process needs to be performed. Specifically, in a case of a storage container which constitutes an optical filter such as an etalon filter, light transmissive window members need to be provided in the front and the back thereof, which leads to increase in number of components, and is a major issue.

### SUMMARY

An advantage of some aspects of the invention is to solve at least a part of the problems described above and the invention can be implemented as the following application examples or modes.

### Application Example 1

This application example is directed to an optical device storage package including a storage portion configured to store an optical device, a base portion which constitutes a bottom portion of the storage portion, a side wall portion integrally formed with the base portion and constituting a side surface portion of the storage portion, and a first lid portion joined to the side wall portion so as to cover the storage portion, constituting a top portion opposing the bottom portion of the storage portion, wherein the first lid portion is formed of a light-transmissive member.

The optical device storage package of this application example includes the base portion which constitutes the bottom portion of the storage portion, the side wall portion which is molded integrally with the base portion and constitutes the side surface portion of the storage portion, and the first lid portion which constitutes the top portion of the storage portion and which is formed of a light-transmissive member which hermetically seals the top portion. Since the first lid portion is formed of the light-transmissive member, necessity of provision of a window that allows the optical device stored in the interior (the storage portion) of the storage package to receive light irradiated from the outside is eliminated. The base portion and the side wall portion are molded integrally, and the first lid portion is joined to the side wall portion. In this manner, according to this application example, the optical device storage package may be composed of a small number of components. Consequently, the number of points where the parts are joined to each other may be reduced, and hence reliability of the sealing hermeticity may be improved. In addition, since the number of components may be reduced, further cost reduction is achieved.

### Application Example 2

This application example is directed to the optical device storage package according to the application example described above, wherein the base portion includes: an opening opened at part of the storage portion; and a second lid portion configured to hermetically seal the opening, and the second lid portion is formed of a light-transmissive member.

According to the optical device storage package of this application example, the optical device storage package further includes a base portion having an opening opened at part of the storage portion and a light-transmissive second lid portion configured to hermetically seal the opening. In other words, light-transmissive lid portions are provided at the top portion and the bottom portion. In this configuration, the optical device such as an optical filter which not only receives light, but also allows passage of light therethrough.

In particular, in the optical filter having a movable portion such as an etalon filter, it is necessary to maintain the storage portion of the optical device at a reduced pressure environment in order to maintain stable optical characteristics. The optical device storage package including a small number of components and accordingly having a small number of joint points as in this application example provides a package having a high sealing hermeticity, so that the optical device storage package is suitable for storing the optical device as described above.

### Application Example 3

This application example is directed to the optical device storage package according to the application example described above, wherein when the thickness of the first lid portion is defined as T1, and the thickness of the second lid portion is defined as T2, the relationship T1 > T2 is satisfied.

According to this application example, the thickness of the first lid portion is larger than the thickness of the second lid portion. The first lid portion is joined to the side wall portion so as to cover the storage portion and hermetically seals the top portion of the storage portion. The second lid portion hermetically seals the opening which is part of the storage portion opening through the base portion. When the storage portion is maintained at a reduced pressure and the optical device is stored, a larger pressure (differential pressure with respect to the atmospheric pressure) in comparison with the second lid portion is applied to the first lid portion coming into contact with the storage portion over a wide surface area. Therefore, in such a case, by setting the thickness of the first lid portion to be larger than the thickness of the second lid portion, the reduced pressure of the storage portion 2 may be set to be lower, so that an optical device storage package which achieves far superior optical characteristics may be provided.

### Application Example 4

This application example is directed to the optical device storage package according to the application example described above, wherein the first lid portion includes a light-shielding mask configured to block part of light passing therethrough into the storage portion.

In this application example, the optical device storage package according to the application example described above is provided with the light-shielding mask configured to block part of light passing through the storage portion on the first lid portion. Depending on the characteristics the usage circumstances or functions to be used of the optical device to be stored in the storage portion, better characteristics are obtained by blocking part of light passing through the first lid portion into the storage portion. For example, when controlling and limiting the direction, the position, and the amount of light entering the optical device are wanted, they are achieved by changing the pattern of the light-shielding mask. In other words, in the related art, it is necessary to take a complicated method including forming the opening having a desired size which does not allow passage of light at a desired position of the lid member, and preparing the window member corresponding to the opening and mounting on the opening. However, according to this application example, this is achieved simply by changing the pattern of the light-shielding mask. Consequently, an increase of the universality of the member (the lid portion in this case) which constitutes the optical device storage package is enabled, and further cost reduction is achieved.

### Application Example 5

This application example is directed to the optical device storage package according to the application example described above, wherein the light-shielding mask is formed of a metal layer laminated on the first lid portion.

According to this application example, the light-shielding mask is formed of a metal layer laminated on the first lid portion. For example, the light-shielding mask is formed by vapor-depositing the metal layer on the first lid portion. In other words, the control of light with which the optical device is irradiated may be performed further simply and flexibly depending on the type, the thickness, and the laminate mask pattern (shape, position, size) of metal to be laminated.

### Application Example 6

This application example is directed to the optical device storage package according to the application example described above, wherein the joint surface of the first lid portion to be joined to the side wall portion is formed with the same metal layer as the metal layer which constitutes the light-shielding mask, and the side wall portion and the first lid portion are joined by brazing filler metal.

According to this application example, in the optical device storage package of the application example described above, the joint surface of the first lid portion to be joined to the side wall portion is further formed with a metal layer, and the side wall portion and the first lid portion are joined by brazing filler metal. The metal layer which constitutes the light-shielding mask and the metal layer provided on the joint surface of the first lid portion are formed of the same metal layer.

For example, when the joint surface of the side wall portion with respect to the first lid portion is formed of metal, by joining the first lid portion and the side wall portion having a metal layer on the joint surfaces thereof by a brazing filler metal, a joint portion having a higher reliability in sealing hermeticity is achieved. More specifically, when coefficients of thermal expansion are significantly different among the side wall portion, the base portion, and the first lid portion, a thermal stress is applied to the joint portion due to a temperature history. When the thermal stress exceeds the joint strength or the rigidity of the joint member, the joint portion may be broken and hence the sealing hermeticity of the storage portion is impaired. In general, for example, in comparison with a case of being joined by a low-melting-point glass or the like, a higher joint strength is achieved when being joined by alloy junction using a brazing filler metal. Therefore, an optical device storage package having a higher reliability in sealing hermeticity is achieved.

### Application Example 7

This application example is directed to an optical filter device including: an optical device storage package and an optical filter as an optical device stored in the optical device storage package, and the optical device storage package includes: a storage portion configured to store an optical device; a base portion which constitutes a bottom portion of the storage portion; a side wall portion which is molded integrally with the base portion and constituting a side surface portion of the storage portion; a first lid portion constituting a top portion joined to the side wall portion so as to cover the storage portion and opposing the bottom portion of the storage potion, and is configured to hermetically seal the top portion, and the first lid portion is formed of a light-transmissive member.

According to this application example, the optical filter is stored in the optical device storage package having a small number of components and capable of maintaining the internal hermeticity desirably even when a thermal stress is applied. Therefore, an optical filter device having a higher environmental resistant performance is provided at lower costs.

### Application Example 8

This application example is directed to an optical module including an optical device storage package and an optical device stored in the optical device storage package, and the optical device storage package includes: a storage portion configured to store an optical device; a base portion which constitutes a bottom portion of the storage portion; a side wall portion which is molded integrally with the base portion and which constitutes a side surface portion of the storage portion; and a first lid portion joined to the side wall portion so as to cover the storage portion, constituting a top portion opposing the bottom potion of the storage portion, and hermetically sealing the top portion, and the first lid portion is formed of a light-transmissive member.

According to this application example, the optical device is stored in the optical device storage package having a small number of components and capable of maintaining the internal hermeticity desirably even when a thermal stress is applied. Therefore, an optical module having a higher environmentally-resistant performance is provided at lower costs.

### Application Example 9

This application example is directed to an electronic apparatus including an optical device storage package and an optical device stored in the optical device storage package, and the optical device storage package includes: a storage portion configured to store an optical device; a base portion which constitutes a bottom portion of the storage portion; a side wall portion which is molded integrally with the base portion and which constitutes a side surface portion of the storage portion; and a first lid portion joined to the side wall portion so as to cover the storage portion, constituting a top portion opposing the bottom potion of the storage portion, and hermetically sealing the top portion, wherein the first lid portion is formed of a light-transmissive member.

According to this application example, the optical device provided in the electronic apparatus is stored in the optical device storage package having a small number of components and capable of maintaining the internal hermeticity desirably even when a thermal stress is applied. Therefore, an electronic apparatus having a higher environmentally-resistant performance is provided at lower costs.

### BRIEF DESCRIPTION OF THE DRAWINGS

The invention will be described with reference to the accompanying drawings wherein like numbers reference like elements.
Fig. 1A is a cross-sectional view illustrating an optical device storage package and an optical filter device according to Embodiment 1.
Fig. 1B is a cross-sectional view illustrating an optical device storage package and an optical filter device configured according to the related art.
Fig. 2A is a cross-sectional view illustrating an optical device storage package and an optical filter device according to Embodiment 2.
Fig. 2B is a cross-sectional view illustrating an optical device storage package and an optical filter device according to Embodiment 3.
Fig. 3 is a block diagram illustrating a schematic configuration of a colorimetric sensor as an optical module and a colorimetric apparatus as an electronic apparatus according to Embodiment 4.
Fig. 4 is a cross-sectional view illustrating an optical device storage package according to a modification.

### DESCRIPTION OF EXEMPLARY EMBODIMENTS

An embodiment in which the present invention is embodied will be described with reference to the drawings. Following is a description of an embodiment of the invention, and is not intended to limit the invention. The respective drawings given below may be drawn in scales different from reality for understandable description.

### Embodiment 1

First of all, an optical device storage package 100 and an optical filter device 200 according to Embodiment 1 will be described.

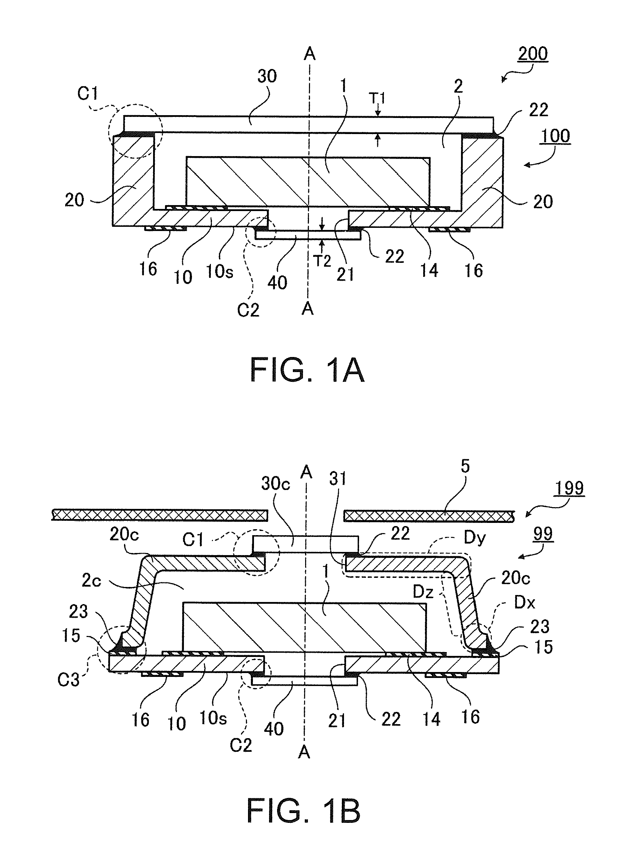

Fig. 1A is a cross-sectional view illustrating an optical filter device 200 including an etalon filter (hereinafter referred to as etalon 1) as an optical device stored in the optical device storage package 100 as an example of the optical filter device.

The optical filter device 200 is an apparatus configured to extract light having a predetermined intended wavelength from incoming light, and includes the optical device storage package 100 having the etalon 1 as an optical device stored therein. The optical filter device 200 as described above may be integrated into an optical module such as a colorimetric sensor or an electronic apparatus such as a colorimetric apparatus or a gas analyzing apparatus. The configuration of the optical module or the electronic apparatus provided with the optical filter device 200 will be described in Embodiment 4 described later.

The etalon 1 is a wavelength variable interference filter (an optical element with parallel surfaces used to increase the coherent length of a laser), and is a rectangular plate-shaped optical device. A description of the etalon 1 will be omitted.

The optical device storage package 100 is an optical device storage package having the storage portion 2 configured to store the etalon 1, and includes a base portion 10, a side wall portion 20, a first lid portion 30, an opening 21, and a second lid portion 40.

The optical device storage package 100 in this embodiment stores the etalon 1 as an example of the optical device. However, the optical device is not limited to the etalon 1, and may be other optical devices.

The base portion 10 is a flat plate constituting a bottom portion of the storage portion 2 and is constituted by, for example, a single layer ceramic substrate. On the base portion 10, the etalon 1 is placed. The etalon 1 is fixed to the base portion 10, for example, via an adhesive agent. Instead of fixation with the adhesive agent, fitting with other fixing members, or fixing by being sandwiched may also be employed.

The surface of the base portion 10 on which the etalon 1 is mounted is provided with a conductive pattern 14 to be connected to a surface of the etalon 1 having an electric component. Although illustration of a detailed connection between the surface of the etalon 1 having the electric component and the conductive pattern 14 is omitted, for example, connection may be achieved with Ag paste, ACF (anisotropic Conductive Film), ACP (Anisotropic Conductive Paste) or the like by using an FPC (Flexible Printed Circuits). In order to maintain the storage portion 2 at a reduced pressure, Ag paste which emits less gas is preferably used. Connection is not limited to FPC and the like and, for example, wiring connection by wire bonding may be implemented.

The base portion 10 is formed with a circular opening 21 which allows passage of light in an area opposing the etalon 1. The shape of the opening 21 is not limited to a circular shape, and triangle, rectangle, polygon, or a combination thereof may be employed.

An external connecting terminal 16 is formed on the outer wall surface 10s (a surface opposite to the surface on which the etalon 1 is mounted) of the base portion 10. The conductive pattern 14 and the external connecting terminal 16 are connected by a wiring pattern formed in the interior of the base portion 10.

The side wall portion 20 is a frame member which constitutes a side surface portion of the storage portion 2, and is formed of, for example, a laminated ceramic board. The side wall portion 20 is formed integrally with the base portion 10 so as to be laminated on the base portion 10.

The first lid portion 30 is a glass substrate constituting a top portion opposing the bottom portion of the storage portion 2. The first lid portion 30 is joined to the side wall portion 20 so as to cover the storage portion 2, and hermetically seals the top portion of the storage portion 2.

The second lid portion 40 is a glass substrate configured to cover the opening 21 from the outside of the storage portion 2. The second lid portion 40 is joined to the outer wall surface 10s of the base portion 10 forming the opening 21, and hermetically seals the opening 21.

In other words, the storage portion 2 is a void surrounded by the base portion 10, the side wall portion 20, the first lid portion 30, and the second lid portion 40 and is hermetically sealed by the first lid portion 30 and the second lid portion 40.

A thickness T1 of the first lid portion 30 is double a thickness T2 of the second lid portion 40. It is desirable to set the thickness T1 of the first lid portion 30 and the thickness T2 of the second lid portion 40 as needed depending on the rigidity of the optical device storage package 100 or the level of the reduction in pressure of the storage portion 2. Therefore, the thickness T1 and the thickness T2 are asset so as to satisfy the relationship of T1 > T2.

Center points of flat surfaces of the first lid portion 30 and the second lid portion 40 pass at substantially center points of flat surfaces of the opening 21 and the etalon 1, are arranged so as to be positioned on a line A-A which is vertical to the base portion 10.

In such a configuration, light enters from the first lid portion 30, and light having a desired wavelength extracted from the etalon 1 goes out from the second lid portion 40.

The first lid portion 30 and the second lid portion 40 are not limited to the glass substrate, and substrates formed of crystal, silicon, germanium or the like may be employed depending on the wavelength of light which is to be passed therethrough.

Joint between the side wall portion 20 and the first lid portion 30 and joint between the base portion 10 and the second lid portion 40 are achieved by the joint member 22. Glass frit, which is a fraction of glass obtained by melting a glass material at a high temperature and quenching, may be employed as the joint member 22. In a case of joint performed by sintering the glass frit (glass frit joint), no gap is formed at the joint portion. In addition, by using the glass frit which emits less gas, the storage portion 2 may be maintained at a reduced pressure. The joint is not limited to the glass flit joint, and joint by adhesion using a low-melting-point glass, or glass sealing may be employed.

Fig. 1B is a cross-sectional view of an optical device storage package 99 and an optical filter device 199 having a structure of the related art.

The optical device storage package 99 includes a storage portion 2c for storing the etalon 1, and includes the base portion 10, a lid 20c, a first lid portion 30c, openings 21, 31, and a second lid portion 40. In the optical device storage package 100, the base portion 10 and the side wall portion 20 are molded integrally. However, the base portion 10 and the lid 20c are provided separately in the optical device storage package 99.

The lid 20c is a metallic lid member for the base portion 10 which constitutes the bottom portion of the storage portion 2c. The lid 20c constitutes a side surface portion and a top portion of the storage portion 2c, and does not allow passage of light from the outside. Therefore, in order to allow light to pass through the storage portion 2c, the lid 20c is provided with the opening 31 at a center area of the top portion. More specifically, the lid 20c includes a lid joint portion Dx to be joined to a peripheral portion of the base portion 10, a side wall portion Dz continuing from the lid joint portion Dx and extending upright away from the base portion 10 and a top surface portion Dy continuing from the side wall portion Dz and covering the etalon 1. The lid 20c is formed, for example, of kovar, 42 alloy, aluminum, copper, or duralumin. The base portion 10 is provided on the outer peripheral edge portion thereof with a joint pattern 15 formed of, for example, Ni or Au, and the lid joint portion Dx and the peripheral edge portion of the base portion 10 are brazed by brazing filler metal 23 (for example, silver solder or the like) via the joint pattern 15.

The opening 31 is provided with a first lid portion 30c for hermetically sealing the storage portion 2c. The first lid portion 30c is a glass substrate configured to cover the opening 31 from the outside of the storage portion 2c and to be joined to an outer wall surface of the top surface portion Dy which is formed with the opening 31. A joint between the lid 20c and the first lid portion 30c is achieved by the joint member 22.

In this manner, the optical device storage package 99 has many components, and hence has a problem of high costs. In addition, in order to maintain the storage portion 2c at a reduced pressure, three joint points C1 to C3 need to be hermetically sealed. In order to secure and maintain high reliability in sealing hermeticity, strict control of members which constitute the joint points and a joint process needs to be performed.

As illustrated in Fig. 1B, there is a case where the optical filter device 199 is used with a light-shielding plate 5 provided separately from the optical filter device 199. In this case, there is no necessity to use an opaque member for the lid 20c.

As regards these problems, according to the optical device storage package and the optical filter device of this embodiment, following advantages may be obtained.

The optical device storage package 100 includes the base portion 10 which constitutes the bottom portion of the storage portion 2, the side wall portion 20 which is molded integrally with the base portion 10 and constitutes the side surface portion of the storage portion 2, and the first lid portion 30 which constitutes the top portion of the storage portion 2 and includes a light-transmissive member which hermetically seals the top portion. Since the first lid portion 30 is formed of the light-transmissive member, necessity of provision of a window that allows the optical device (etalon 1) stored in the interior (the storage portion 2) of the optical device storage package 100 to receive light irradiated from the outside is eliminated. The base portion 10 and the side wall portion 20 are molded integrally, and the first lid portion 30 is joined to the side wall portion 20. In this manner, according to this embodiment, the optical device storage package may be configured with a small number of components. Consequently, the number of points where the parts are joined to each other may be reduced (more specifically, only two joint points C1, C2 illustrated in Fig. 1A are sufficient), and hence reliability of the sealing hermeticity may be improved. In addition, since the number of components may be reduced, further cost reduction is achieved.

In this configuration, the thickness T1 of the first lid portion 30 is larger than the thickness T2 of the second lid portion 40. The first lid portion 30 is joined to the side wall portion 20 so as to cover the storage portion 2 and hermetically seals the top portion of the storage portion 2. The second lid portion 40 hermetically seals the opening 21 which is part of the storage portion 2 opening through the base portion 10. When the storage portion 2 is maintained at a reduced pressure and the optical device (etalon 1) is stored, a larger pressure (differential pressure with respect to the atmospheric pressure) in comparison with the second lid portion 40 is applied to the first lid portion 30 coming into contact with the storage portion 2 over a wide surface area. Therefore, in such a case, by setting the thickness T1 of the first lid portion 30 to be larger than the thickness T2 of the second lid portion 40, the reduced pressure of the storage portion 2 may be set to be lower, so that an optical device storage package which achieves far superior optical characteristics may be provided.

### Embodiment 2

Subsequently, an optical device storage package 101 and an optical filter device 201 according to Embodiment 2 will be described. In the description, portions having the same configuration as the above-described embodiment are designated by the same reference numerals and overlapped description will be omitted.

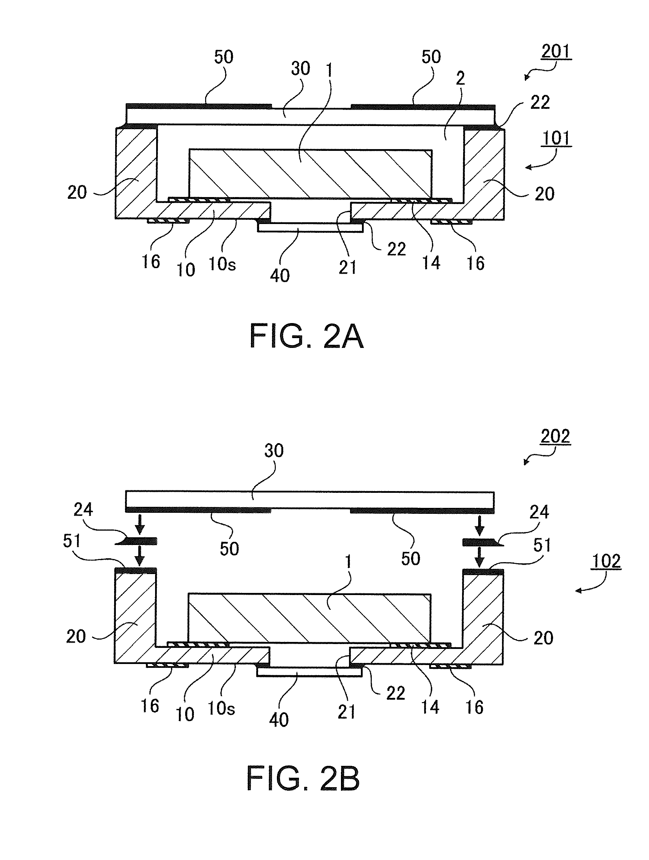

Fig. 2A is a cross-sectional view of an optical filter device 201 in which the etalon 1 as the optical device is stored in the optical device storage package 101.

In Embodiment 2, the first lid portion 30 is provided with a light-shielding mask 50 which blocks part of light passing therethrough to the storage portion 2. Except for this point, Embodiment 2 is the same as Embodiment 1.

The optical device storage package 101 is provided with the light-shielding mask 50 configured to block part of light passing through the first lid portion 30 into the storage portion 2 in addition to the configuration of the optical device storage package 100. The light-shielding mask 50 is formed of a metal layer laminated on the surface of the first lid portion 30 opposite to the joint surface of the first lid portion 30 with respect to the side wall portion 20. The metal layer is formed by vapor-depositing or spattering chrome, nickel, titanium, titan tungsten, gold, aluminum, or copper.

The light-shielding mask 50 is effective when the light-shielding plate 5 provided separately from the optical filter device 199 as illustrated in Fig. 1B is not employed as the optical filter device. Specifically, depending on the characteristics, the usage environment, and the function to be used of the optical device to be stored in the storage portion 2, better characteristics are obtained by blocking part of light passing through the first lid portion 30 into the storage portion 2. For example, when controlling and limiting the direction, the position, and the amount of light entering the etalon 1 are wanted, they are achieved by changing the pattern of the light-shielding mask 50. Therefore, the type, the thickness, and the laminate mask pattern (shape, position, size) of metal to be laminated as the light-shielding mask 50 are properly set by the characteristics, the usage environment, and the function to be used of the optical device to be stored.

According to the optical device storage package and the optical filter device of this embodiment, following advantages may be obtained in addition to the above-described advantages of the embodiment.

In the related art, as illustrated in fig. 1B, it is necessary to take a complicated method including forming the opening 31 having a desired size at a desired position of the lid 20c which does not allow passage of light, and preparing the first lid portion 30c as a window member corresponding to the opening 31 and mounting the first lid portion 30c on the opening 31. However, according to this embodiment, this is achieved simply by changing the pattern of the light-shielding mask 50. In other words, the control of light with which the optical device is irradiated may be performed further simply and flexibly depending on the type, the thickness, and the laminate mask pattern (shape, position, size) of metal to be laminated as the light-shielding mask 50. Consequently, an increase of the universality of the member (the first lid portion 30 in this case) which constitutes the optical device storage package 101 is enabled, and further cost reduction is achieved.

Also, the light-shielding mask 50 may be formed of a metal layer laminated on the same surface as the joint surface with respect to the side wall portion 20 of the first lid portion 30 (that is, the surface coming into contact with the storage portion 2). The light-shielding mask 50 is not limited to the vapor-deposited metal layer, and may have a configuration in which a light-shielding film or a plastic plate is adhered to the first lid portion 30.

### Embodiment 3

Subsequently, an optical device storage package 102 and an optical filter device 202 according to Embodiment 3 will be described. In the description, portions having the same configuration as the above-described embodiment are designated by the same reference numerals and overlapped description will be omitted.

Fig. 2B is a cross-sectional view of a configuration of an optical filter device 202 in which the etalon 1 as the optical device is stored in the optical device storage package 102.

In Embodiment 3, the first lid portion 30 is provided with a light-shielding mask 50 which blocks part of light passing through the storage portion 2, and on a joint surface of the first lid portion 30 which is joined to the side wall portion 20, a metal layer is provided which is formed of the same metal layer which constitutes the light-shielding mask 50, and the side wall portion 20 and the first lid portion 30 are joined by a brazing filler metal 24 (for example, silver solder).

The light-shielding mask 50 is formed of a metal layer laminated on the same surface as the joint surface with respect to the side wall portion 20 of the first lid portion 30 (the surface coming into contact with the storage portion 2). The metal layer which constitutes the light-shielding mask 50 is also formed on the joint surface of the first lid portion 30 joined to the side wall portion 20. These members (the light-shielding mask 50 and the metal layer of the joint surface) may be formed continuously.

The metal layer 51 is also laminated on the joint surface of the side wall portion 20 with respect to the first lid portion 30.

Both of the first lid portion 30 and the side wall portion 20 are brazed at joint portion (joint surfaces thereof) by the brazing filler metal 24.

Fig. 2B illustrates a state in which the first lid portion 30, the brazing filler metal 24, and the side wall portion 20 are separated for the sake of easy understanding.

Except for this point, Embodiment 3 is the same as Embodiment 1.

According to the optical device storage package and the optical filter device of this embodiment, following advantages may be obtained in addition to the above-described advantages of the embodiment.

By joining the first lid portion 30 and the side wall portion 20 having a metal layer on the joint surfaces thereof by a brazing filler metal 24, a joint portion having a higher reliability in sealing hermeticity is achieved. More specifically, when coefficients of thermal expansion are significantly different among the side wall portion 20, the base portion 10, and the first lid portion 30, a thermal stress is applied to the joint portion due to a temperature history. When the thermal stress exceeds the joint strength or the rigidity of the joint member, the joint portion may be broken and hence the hermeticity of the storage portion 2 is impaired. For example, in comparison with a case of being joined by low-melting-point glass or the like, higher joint strength is achieved in a case of alloy junction by the brazing filler metal 24, so that an optical device storage package having a higher reliability in sealing hermeticity is achieved.

### Embodiment 4

Subsequently, an optical module and an electronic apparatus according to Embodiment 4 will be described. In the description, portions having the same configuration as the above-described embodiment are designated by the same reference numerals and overlapped description will be omitted.

In Embodiment 4, a colorimetric sensor 1000 as an optical module in which the optical filter device 200 is integrated, and a colorimetric apparatus 2000 as an electronic apparatus in which the colorimetric sensor 1000 is integrated will be described. Here, an example in which the optical filter device 200 is integrated will be described. However, the optical filter device 201 and the optical filter device 202 are also applicable.

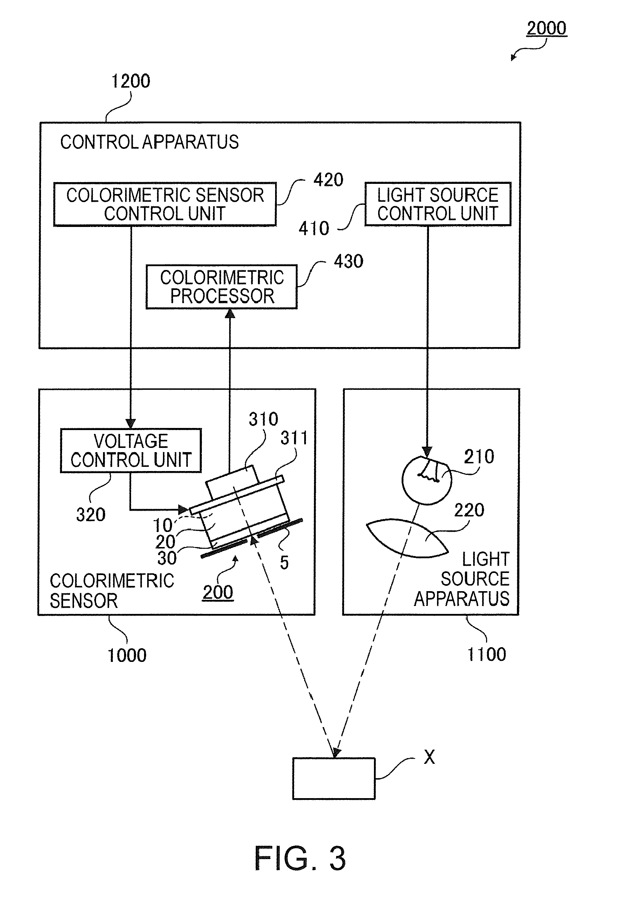

Fig. 3 is a block diagram illustrating a schematic configuration of the colorimetric apparatus 2000.

The colorimetric apparatus 2000 includes a light source apparatus 1100 configured to emit light to a test object X and a control apparatus 1200 configured to control the entire operation of the colorimetric apparatus 2000 as illustrated in Fig. 3. The colorimetric apparatus 2000 is an apparatus configured to cause light emitted from the light source apparatus 1100 to be reflected from the test object X, receive the reflected test object light by the colorimetric sensor 1000, and analyze and measure the chromaticity of the test object light, that is, the color of the test object X on the basis of a detection signal output from the colorimetric sensor 1000.

The light source apparatus 1100 is provided with a light source 210, and a plurality of lenses 220 (only one of those is illustrated in Fig. 3), and emits white light to the test object X. Also, the lenses 220 may include a collimator lens and, in this case, the light source apparatus 1100 converts the white light emitted from the light source 210 into a parallel light by the collimator lens, and emits the parallel light from a projection lens, not illustrated toward the test object X. In this embodiment, the colorimetric apparatus 2000 provided with the light source apparatus 1100 is exemplified. However, when the test object X is a light-emitting member such as a liquid crystal panel, a configuration in which the light source apparatus 1100 is not included is applicable.

The colorimetric sensor 1000 is provided with the optical filter device 200. The colorimetric sensor 1000 includes the optical filter device 200, a detecting unit 310 configured to receive the light passed through the etalon 1 of the optical filter device 200, and a voltage control unit 320 configured to vary the wavelength of light which is caused to be passed through the etalon 1 as illustrated in Fig. 3.

The colorimetric sensor 1000 is provided with an incident optical lens, not illustrated, configured to guide the reflected light reflected from the test object X (the test object light) into the interior at a position opposing the etalon 1. Then, the colorimetric sensor 1000 splits light having a predetermined wavelength from the test object light entering from the incident optical lens by the etalon 1 in the optical filter device 200, and receives the split light by the detecting unit 310.

The front surface (the surface where the light enters) of the optical filter device 200 is provided with the light-shielding plate 5, so that entry of stray light with respect to the etalon 1 is avoided. However, depending on the configuration of a housing of the colorimetric sensor 1000 or an incident optical lens not shown does not need to be provided with the light-shielding plate 5 in case of Embodiment 2 and Embodiment 3.

The detecting unit 310 includes a plurality of photoelectric transfer elements, and generates an electric signal corresponding to the amount of received light. Here, the detecting unit 310 is connected to the control apparatus 1200 via the circuit board 311, and outputs the generated electric signal to the control apparatus 1200 as a light-emitting signal. An external connecting terminal 16 (see Fig. 1A) formed on the base portion 10 is connected to the circuit board 311, and is connected to the voltage control unit 320 via a circuit formed on the circuit board 311.

In this configuration, the optical filter device 200 and the detecting unit 310 are integrally configured via the circuit board 311, and the configuration of the colorimetric sensor 1000 may be simplified.

The voltage control unit 320 is connected to the external connecting terminal 16 of the optical filter device 200 via the circuit board 311. Then, the voltage control unit 320 applies a predetermined step voltage to the etalon 1 on the basis of the control signal input from the control apparatus 1200, so that a predetermined wavelength to be split may be set.

The control apparatus 1200 controls the entire operation of the colorimetric apparatus 2000.

Examples of the control apparatus 1200 include, for example, a universal personal computer, a personal digital assistance, and other colorimetric specific computer.

The control apparatus 1200 includes a light source control unit 410, a colorimetric sensor control unit 420, and a colorimetric processor 430 as illustrated in Fig. 3.

The light source control unit 410 is connected to the light source apparatus 1100, and on the basis of the set input of the user, for example, outputs a predetermined control signal to the light source apparatus 1100, and causes the light source apparatus 1100 to emit white light having a predetermined brightness.

The colorimetric sensor control unit 420 is connected to the colorimetric sensor 1000, sets the wavelength of the light to be received by the colorimetric sensor 1000, for example, based on the setting input by the user, and outputs a control signal indicating that the amount of received light having this wavelength is to be detected to the colorimetric sensor 1000. Accordingly, the voltage control unit 320 of the colorimetric sensor 1000 sets an application voltage to the etalon 1 so that only light having a wavelength desired by the user is transmitted on the basis of the control signal.

The colorimetric processor 430 analyzes the chromaticity of the test object X from the amount of received light detected by the detecting unit 310.

As described above, according to the colorimetric sensor 1000 as the optical module and the colorimetric apparatus 2000 as the electronic apparatus according to this embodiment, the following advantages are achieved.

The colorimetric apparatus 2000 of this embodiment includes the optical filter device 200. As described above, in the optical filter device 200, the optical filter (etalon 1) is stored in the optical device storage package 100 that includes a small number of components, and maintains the internal hermeticity desirably even when a thermal stress is applied. Therefore, the optical module and the electronic apparatus having a higher environment resistant performance may be provided at lower costs.

The invention is not limited to the embodiments described above, and may be implemented with various modifications or improvement applied to the above-described embodiment. Modifications will be described below. In the description, portions having the same configuration as the above-described embodiment are designated by the same reference numerals and overlapped description will be omitted.

### Modification

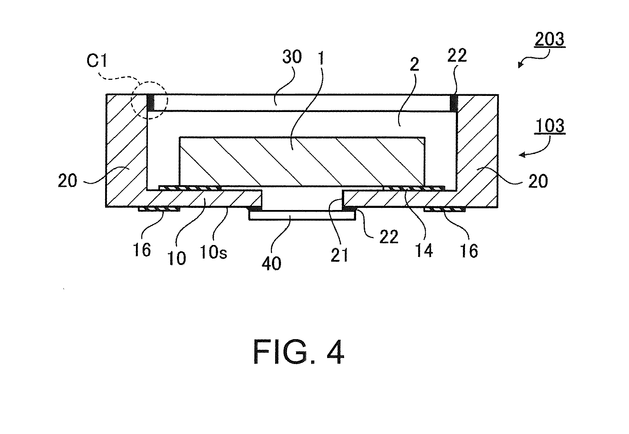

Fig. 4 is a cross-sectional view illustrating an optical device storage package 103 (optical filter device 203) according to Modification.

As an example, a variation of a joint structure at the joint portion C1 is illustrated.

In Embodiment 1, the first lid portion 30 is joined to the side wall portion 20 so as to cover the storage portion 2, and is hermetically seals the top portion of the storage portion 2. In Fig. 1A, the first lid portion 30 is illustrated so as to overlap with an upper portion of the side wall portion 20 (an upper portion of a surface parallel to the direction of extension of the first lid portion 30). However, this modification is not limited thereto.

As the optical device storage package 103 illustrated in Fig. 4, the configuration in which the side surface of the first lid portion 30 joins the inner wall surface of the side wall portion 20 may be employed.

With the joint portion C1 having the configuration as described above, there is a case where a joint portion stronger for the thermal stress generated by the difference in coefficient of thermal expansion among members which constitute the optical device storage package 103 can be constituted. For example, when the direction of main thermal stress acts from the side surface of the first lid portion 30 in the direction of compressing the first lid portion 30, the thermal stress acts on the joint member 22 as a shear stress in the optical device storage package 100 illustrated in Fig. 1A, while the thermal stress acts as a compression stress in the optical device storage package 103 illustrated in Fig. 4. In general, at the joint portion, the resistance against the compression stress is higher than the shear stress. In such a case, the stronger joint portion may be configured.

In this manner, the joint structure matching the member to be used or the environment of usage is preferably employed.

The entire disclosure of Japanese Patent Application example No. 2013-009018 filed on 1/22/2013 is expressly incorporated by reference herein.

## Claims

1. An optical device storage package comprising:
a storage portion configured to store an optical device;
a base portion which constitutes a bottom portion of the storage portion;
a side wall portion which is molded integrally with the base portion and which constitutes a side surface portion of the storage portion; and
a first lid portion constituting a top portion opposing the bottom portion of the storage potion, and is configured to hermetically seal the storage portion by being joined to the side wall portion, wherein
the first lid portion is composed of a light-transmissive member.

2. The optical device storage package according to Claim 1, comprising:
a second lid portion configured to hermetically seal the opening, wherein
the second lid portion is formed of a light-transmissive member,
wherein the base portion includes an opening open at a part of the storage portion.

3. The optical device storage package according to Claim 2, wherein when the thickness of the first lid portion is defined as T1, and the thickness of the second lid portion is defined as T2, the relationship T1 > T2 is satisfied.

4. The optical device storage package according to one of the preceding claims, wherein the first lid portion includes a light-shielding mask configured to block a part of light from passing therethrough into the storage portion.

5. The optical device storage package according to Claim 4, wherein the light-shielding mask is formed of a metal layer laminated on the first lid portion.

6. The optical device storage package according to Claim 5, wherein the joint surface of the first lid portion to be joined to the side wall portion is formed with the same metal layer as the metal layer which constitutes the light-shielding mask, and
the side wall portion and the first lid portion are joined by a brazing filler metal.

7. An optical filter device comprising:
an optical device storage package according to one of the preceding claims and an optical filter as an optical device stored in the optical device storage package.

8. An optical module comprising an optical device storage package according to one of the preceding claims and an optical device stored in the optical device storage package,
wherein the first lid portion is joined to the side wall portion so as to cover the storage portion and hermetically seals the top portion.

9. An electronic apparatus comprising:
an optical device storage package according to one of the preceding claims and an optical device stored in the optical device storage package.
